# EUROPEAN PATENT APPLICATION

(11) **EP 4 517 185 A1**
(43) Date of publication of application: **05.03.2025**
(21) Application number: 24196534.2
(22) Date of filing: 26.08.2024
(51) Int. Cl.: F24C 15/02, A47L 15/42, E05D 11/00, F25D 23/02, H05B 6/64, F24C 7/08

(54) **A DOOR FOR A HOME APPLIANCE**

(30) Priority: 29.08.2023 KR 20230113779
(71) Applicant: LG Electronics Inc., Yeongdeungpo-gu Seoul 07336 (KR)
(72) Inventor: LEE, Jeok Lae, Seoul 08592 (KR); KIM, DongWoo, Seoul 08592 (KR); LEE, Wanglim, Seoul 08592 (KR)
(74) Representative: Vossius & Partner Patentanwälte Rechtsanwälte mbB

(57) **Abstract**

The present disclosure relates to a door for home appliances and a home appliance including the same. The present disclosure may include a door body that is coupled to a home appliance and has electronic components disposed therein. A guide device (200) may be placed on the door body The guide device may be moved in a first direction and disposed on the door body The guide device may be supported by the door body in a second direction different from the first direction.

## Description

The present disclosure relates to a door for a home appliance.

Commonly used home appliances, such as cooking appliances, refrigerators, and garment care devices, have a door that provides access to an internal space for storing items. These appliances typically consist of a cabinet exterior, with an interior compartment designed for storing objects, along with a door mechanism for opening and closing this compartment.

Recently, various electronic components are installed inside the door of a home appliance. For example, a touch sensor device or a display device may be installed on the door. These electronic components may be electrically connected via wiring to a main controller located within the main body of the home appliance.

In order to facilitate the connection of such wires, a connector may be coupled to the wires. For example, a door connector pulled out from the door and a body connector pulled out from the main body may be assembled with each other. The door connector and the body connector (hereinafter, referred to as a "connector assembly") assembled with each other are arranged so as not to be exposed to the outside. For example, after the connector assembly is stored inside a frame of the main body adjacent to the door, the entrance to the connector storing portion may be covered with a separate cover.

In this case, assembly of the connector assembly may be performed after first assembling the door to the main body. After assembling the door to the main body, the door connector is assembled to the main body connector. However, there is a disadvantage in that it is difficult to assemble the two connectors because the space between the main body and the door is narrow.

In addition, since the frame of the main body adjacent to the door has a narrow inner space, maintenance of the connector assembly is also difficult. In particular, the built-in type home appliance has a small area exposed to the front, so the entrance of the space that may store connectors and wires is narrow. Since an operator has to access the connector assembly through the narrow inner space of the frame, the workability for maintenance is poor.

In addition, it is difficult to secure a work space for using a tool due to the narrow gap between the main body and the door Since the use of the tool is inconvenient, both the work of assembling the door connector and the body connector and the work of storing them becomes difficult.

Moreover, among home appliances, products that create a high temperature environment in the storing space, such as cooking appliances, also have a high temperature of the home appliance body. Such a high temperature of the main body affects the connector assembly and wire, reducing the durability of the connector assembly and wire, and may lead to damage to the connector assembly or wire.

Furthermore, if the connector assembly is positioned within the home appliance without being securely fixed, it may move around freely, making it difficult to pinpoint its exact location. Consequently, it becomes problematic for the operator to locate the connector assembly when performing maintenance on the electronic component or connector assembly.

In addition, since the wire is made of a flexible material, it is difficult to arrange the wire in the desired direction inside the home appliance. If the wire is arranged in a freely bent state inside the home appliance, it may interfere with other components or may be exposed to the outside.

Particularly, when wires are arranged between parts that move relative to each other, such as between the main body of a home appliance and its door, the wires also move and are pulled along. In this moving process, the direction of the wire may continually change, and the wire may even become detached from its mounted position. Therefore, even if the wire is arranged within a part that operates continuously, it is necessary to maintain a consistent orientation of the wire's extension.

In addition, the wire arranged in the main body of the home appliance and the wire arranged in the door may be fixed with separate fasteners at certain intervals for assembly stability. The connectors provided at the end of the wire fixed to the fastener are limited in the distance and direction of movement. In this case, if the length of the wires is long enough, the working distance for combining the two connectors is extended, which improves the workability, but the section where the wires are exposed to the outside is also lengthened, so the aesthetics are compromised and the durability may be reduced, such as damage to the coating due to friction with the outside. Conversely, if the length of the wires is short, the section where the wires are exposed to the outside is shortened, which improves the aesthetics and reduces friction with the outside, but there is a problem that the workability for assembling the two connectors is reduced.

The present disclosure is to solve the problems of the prior art as described above, and the purpose of the present disclosure is to arrange wires and connectors connected to electronic components placed inside a door after being assembled with a mating connector.

Another purpose of the present disclosure is to align the connector and the wire to the door without using separate fasteners.

Another purpose of the present disclosure is to arrange wires and connectors inside the door so that environmental conditions inside a home appliance do not affect the wires and connectors.

Another purpose of the present disclosure is to ensure that the connector remains attached to a certain position of the door together with the mating connector.

Another purpose of the present disclosure is to keep the wire in a certain direction inside the door when the door opens or closes or the connector enters or exits the door so that it does not invade the viewing part or interfere with other parts.

According to the present disclosure for achieving the above purposes, the present disclosure may include a door body coupled to a home appliance and having an electronic component disposed therein. A guide device for storing a door wire connected to the electronic component may be disposed on the door body. The guide device may be moved in a first direction and disposed on the door body. The guide device may be supported by the door body in a second direction different from the first direction.

The guide device may slide a surface of the door body in the first direction.

The guide device may be supported by the door body in the second direction at a plurality of points.

The guide device may be provided with an elastic support part elastically deformed in the second direction. The elastic support part may be elastically supported by being pressed against a surface of the door body.

The guide device may be provided with a plurality of elastic support parts. The plurality of elastic support parts may be elastically supported on different surfaces of the door body, respectively.

The elastic support part may include a guide leg elastically deformed in a central direction of the guide path from a first surface of the guide device. The elastic support part may include an elastic support protrusion elastically deformed in a central direction of the guide path from a second surface opposite to the first surface.

The guide device may be provided with an elastic support protrusion elastically deformed in the second direction. When the elastic support protrusion is inserted into a protrusion fastening hole provided in the door body, the elastic support protrusion is restored its original shape and be caught in the protrusion fastening hole.

The guide device may be provided with a base body seated on a surface of the door body. The base body may be provided with a support leg that is elastically deformed in the second direction by being pressed against a surface of the door body.

The door body may be provided with an edge part forming an edge of the door body. The edge part may include a first plate constituting a first surface, a second plate constituting a second surface bent from the first surface, and a third plate constituting a third surface facing the first surface. A mounting inlet may be opened between the first plate and the third plate in a direction facing the second plate. The guide device is moved in the first direction and disposed between the first plate and the third plate through the mounting inlet.

The guide device may include an elastic support part that is elastically deformed by being pressed against the first plate or the third plate.

The guide device may include a base body seated on the door body and facing the first plate of the door body. A side body may be erected at one end of the base body. The side body may face the second plate of the door body. A cover body may be connected to the side body. The cover body may face the base body and face the third plate of the door body. A guide path may be provided between the base body, the side body, and the cover body. The base body or the cover body may be supported by the door body in the second direction.

The guide device may be provided with a support leg and an elastic support protrusion that are elastically deformed in opposite directions and elastically supported in the second direction by the door body.

A height between one end of the support leg and one end of the elastic support protrusion may be higher than a height of a guide mounting part provided in the door body.

One end of the guide device may be supported by the door body. The other end of the guide device may be rotated in the first direction with respect to the one end thereof to be mounted on the door body.

The guide device may include a fixing end provided at one end of the guide device and supported at a first point of the door body. The guide device may include a rotating end provided at the other end portion of the guide device. The rotating end may be rotated around the fixing end and supported at a second point of the door body.

The rotating end may be provided with the support leg that is elastically deformed in the second direction by the door body at the second point of the door body.

The elastic support protrusion elastically deformed in the second direction by the door body may be provided between the fixing end and the rotating end. The elastic support protrusion may be pressed against a surface of the door body or inserted into the protrusion fastening hole formed in the door body.

A wire entrance into which a door wire is inserted may be opened at one side of the guide path. The guide device may be provided with a wire holder protruding from the guide path in a direction of narrowing the wire entrance.

The wire holder may be elastically deformed in the second direction to widen the wire entrance.

The wire holder may include a guide surface provided in a direction inclined upward toward the inside of the guide path. The wire holder may include a support surface erected in a direction blocking one end of the guide path. The door wire may be disposed between the support surface and a surface of the guide path.

The wire entrance may be provided with a wire catching protrusion protruding in a direction of narrowing the wire entrance. The wire catching protrusion may be disposed closer to the wire entrance than the wire holder.

The wire holder and the wire catching protrusion may protrude in opposite directions.

A connector holder may protrude from the guide path, and a door connector connected to the door wire may be mounted on the connector holder.

A door panel may be disposed at the center of the door body. The door panel may be provided with a viewing part that allows visibility into a storage area within the home appliance. An installation area surrounding the outside of the viewing part may be provided in the door inner space formed by the door body and the door panel. The guide device may be disposed in the installation area

The door for a home appliance and the home appliance including the same according to the present disclosure as described above have the following effects.

In the present disclosure, a door connector and a door wire connected to electronic components inside the door may be disposed on the door rather than a main body of the home appliance. Since the door connector and the door wire do not have to be disposed in a narrow space between the main body and the door or inside the main body, there is an effect of improving workability for mounting the door connector and the door wire.

In particular, a built-in home appliance body has a limited front exposure, and in the present disclosure, the door connector and the door wire may be stored in the door rather than the main body of the home appliance, so the maintenance of the door connector and the door wire may be improved.

In addition, in the present disclosure, the door connector and the door wire may be stored in the door body through a guide device. The guide device may be disposed in the door body along a first direction and then elastically supported on the door body in a second direction. Accordingly, the door connector and the door wire may be secured to the door body without a separate fastener, thereby reducing the number of parts and assembly operations.

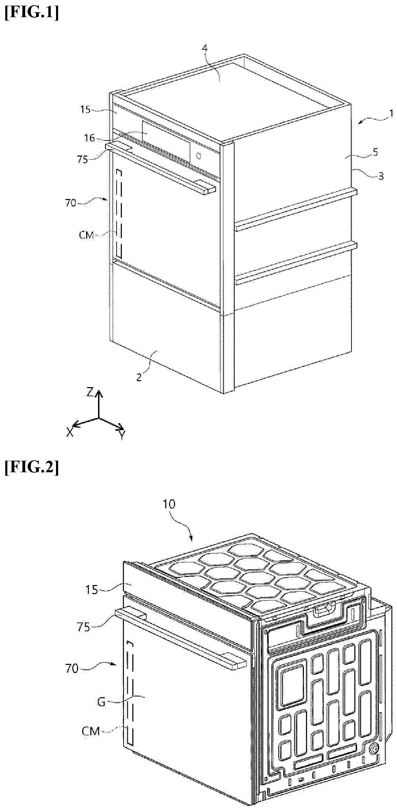

In addition, in the present disclosure, a guide leg constituting an elastic support part may elastically support the guide device in the vertical direction (the X-axis direction of FIG. 1) through elastic deformation. An elastic support protrusion constituting the elastic support part may elastically support the guide device in the front and rear /left and right directions (Y-axis and Z-axis directions of FIG. 1). Accordingly, the guide device may be supported in all directions to maintain a stable secured state to the door body.

And, in the present disclosure, the door connector and a mating connector may be assembled with each other and then stored in the inner space of the door through a guide device. Accordingly, connectors and wires may be less affected by the harsh environment of the main body having excessively high or low temperature and humidity. Therefore, durability of connectors and wires may be improved, and operational reliability of the connectors may be improved.

In addition, the guide device may be disposed between a plurality of panels. The plurality of panels may create an insulating space therebetween. Accordingly, even if the internal temperature of the main body is high, heat transferred to the guide device may be greatly reduced.

In addition, connectors may be assembled or separated from each other at the lower part of the door disposed at the front of the home appliance, thereby improving accessibility to connectors. Accordingly, the assembling/separating workability of the connector may be improved.

In addition, the door of the present disclosure is provided with the guide device, and the guide device is provided with a guide path to store the door wire and the door connector. Accordingly, in the present disclosure, not only the direction of extensions of the wires may be guided, but also the connectors may be fixed in the designated position. In this way, since the connectors are always disposed at the designated position, the operator may easily predict the storing positions of the connectors. Accordingly, the maintainability of the connectors may also be improved.

In addition, in the present disclosure, the wires may extend along the guide path provided inside the guide device. Since the wires are always stored/discharged along a specific path along the guide path, it is possible to prevent the wires from deviating from the designated path and blocking the viewing part in the center of the door. As a result, the aesthetics of doors and home appliances may also be improved.

Particularly, in the present disclosure, the wires and the connectors may be disposed on the edge part (installation area) provided around the viewing part of the door. Accordingly, when the door connector and the mating connector are in the storing position, they may be covered by the edge part and not exposed to the outside.

And, in the present disclosure, the mating wire connected to the mating connector (main body connector) may be stored in the door in a pulled state. If the mating wire is stored in a pulled state, the portion of the mating wire that is stretched out of the door may be reduced. Accordingly, it is possible to prevent the mating wire from rubbing against the ground or the like, and aesthetics may also be improved.

Also, in the present disclosure, the guide device may be disposed in a space provided at an edge of the door frame. Since such a space is a dead space that is not used, there is no need to provide a separate space to store the guide device. In particular, since such a space exists in the door, it may be applied without changing the design of the existing door Accordingly, the present disclosure has high door compatibility and may reduce manufacturing costs.

In the present disclosure, the guide device may surround wires and connectors. Accordingly, the amount of radiant heat emitted from the storage space of the home appliance may be reduced. Accordingly, durability of wires and connectors may be increased.

In addition, in the present disclosure, a guide cover may be assembled with the guide device. Since the guide device may be easily accessed by removing the guide cover, the work of assembling the connectors and storing them in the guide device may be easily performed. Conversely, the work of pulling out the connectors may be easily performed.

In addition, the guide cover may be provided with a connector holder. The connector holder may secure the connectors to the storing position. The connectors may be coupled together through the work of assembling the guide cover. Therefore, it is possible to firmly secure the connector, and the assembly operation for the connector may be reduced.

Also, in the present disclosure, the guide device may be disposed inside the door in a different direction from an electronic component (e.g., an image acquisition module, etc.). When the guide device and the electronic component are arranged in different directions, the internal space of the door may be widely utilized. Accordingly, larger electronic components and guide devices may be applied to the door, increasing the design freedom of the electronic components and the guide device.

In addition, the guide device may be disposed to face at least three or more surfaces of the door body inside the door. Accordingly, the guide device may be firmly supported by the door body.

In addition, the guide device may be in surface contact with the surface of the door body. In the state of surface contact in this way, the guide device may slide along the surface of the door body and be arranged at the edge of the door body. Therefore, the guide device may be easily mounted.

In addition, in the present disclosure, the guide path of the guide device may surround three or more different surfaces of the connectors. Accordingly, the connectors may be stably stored, and separation of the connectors may be prevented.

### Brief Description of the Drawings

FIG. 1 is a perspective view illustrating a state in which a home appliance according to an embodiment of the present disclosure is installed in a built-in manner on furniture.
FIG. 2 is a perspective view showing the home appliance according to the embodiment of the present disclosure.
FIGS. 3 to 5 are assembly flowcharts sequentially showing a process in which a door connector and a mating connector are assembled with each other and then stored in a door according to the embodiment of the present disclosure.
FIG. 6 is an exploded perspective view illustrating components of the door for the home appliance according to the embodiment of the present disclosure.
FIG. 7 is a cross-sectional view illustrating an internal structure of the door for the home appliance according to the embodiment of the present disclosure.
FIG. 8 is a perspective view illustrating a state in which a rear frame part and an inner frame part are removed from the door for the home appliance according to the embodiment of the present disclosure
FIG. 9 is a perspective view of FIG. 8 from a different angle.
FIG. 10 is a perspective view illustrating a state in which a guide cover is separated from a guide device constituting the embodiment of the present disclosure.
FIG. 11 is an enlarged perspective view illustrating a structure of a front frame part constituting the embodiment of the present disclosure.
FIG. 12 is a cross-sectional view taken along a line XII-XII' of FIG. 8.
FIG. 13 is a perspective view illustrating a structure of the guide device constituting the embodiment of the present disclosure.
FIG. 14 is a front view illustrating the structure of the guide device constituting the embodiment of the present disclosure.
FIG. 15 is a plan view illustrating the structure of the guide device constituting the embodiment of the present disclosure.
FIGS. 16 to 18 are work flowcharts sequentially showing a process of storing a door connector and a mating connector inside the guide device constituting the embodiment of the present disclosure.
FIG. 19 is a cross-sectional view taken along the line XIX-XIX' of FIG. 9.
FIG. 20 is a cross-sectional view taken along the line XX-XX' in FIG. 18.
FIG. 21 is a perspective view illustrating a structure of the guide cover constituting the embodiment of the present disclosure.
FIGS. 22 to 23 are assembly flowcharts sequentially showing the process of assembling the guide device to the door body constituting the embodiment of the present disclosure.
FIGS. 24 to 30 are assembly flowcharts sequentially showing the process of assembling a guide device to a door body constituting another embodiment of the present disclosure.
FIG. 31 is a cross-sectional view illustrating a third embodiment of the guide device constituting a door for a home appliance according to the present disclosure.
FIG. 32 is a cross-sectional view illustrating a fourth embodiment of a guide device constituting a door for a home appliance according to the present disclosure.
FIG. 33 is a cross-sectional view illustrating a fifth embodiment of a guide device constituting a door for a home appliance according to the present disclosure.
FIG. 34 is a plan view illustrating a sixth embodiment of a guide device constituting a door for a home appliance according to the present disclosure.
FIG. 35 is a plan view illustrating a seventh embodiment of a guide device constituting a door for a home appliance according to the present disclosure.
FIG. 36 is an exemplary view illustrating a refrigerator to which the door for the home appliance is applied according to the present disclosure.
FIG. 37 is an exemplary view showing an oven to which the door for the home appliance is applied according to the present disclosure.

### Detailed Description of the Disclosure

Hereinafter, some embodiments of the present disclosure will be described in detail with reference to exemplary drawings. In adding reference numerals to components of each drawing, it should be noted that the same components have as much as possible the same numerals even though they are displayed on different drawings. Also, in describing an embodiment of the present disclosure, when it is determined that a detailed description of a related known configuration or function interferes with the understanding of the embodiment of the present disclosure, the detailed description thereof will be omitted.

The present disclosure relates to a home appliance and a door for the home appliance (hereinafter, referred to as a "door 70"). Here, the home appliance means that a storage space is therein. The door 70 may be disposed in front of the storage space. Here, the front means a direction toward a user when the user is positioned in front of the home appliance. Referring to FIG. 1, the X-axis direction may be front. The Y-axis direction may be a width direction of the door 70. The Z-axis direction may be a height direction of the door 70. Hereinafter, the description will be made based on this direction.

The door 70 for the home appliance may be applied not only to the door 70 of the home appliance such as a cooking appliance, a refrigerator, a freezer, a kimchi refrigerator, a plant growing apparatus, a garment care device, a washing machine, and the like, but also to furniture doors or entrance doors. The present disclosure may be applied to various home appliances provided with one or a plurality of doors 70. Among them, cooking appliances may include sealed cooking appliances such as ovens and microwave ovens. Hereinafter, the door 70 of the present invention will be described as an example applied to a cooking appliance.

In the present embodiment, an electronic component may be disposed inside the door 70. The electronic component may provide various functions to the door 70. For example, when the electronic component is an image acquisition module 100, an internal image of a storage space may be acquired through the image acquisition module 100. The door 70 may increase the internal illuminance of the storage space. To this end, the image acquisition module 100 may include an image sensing device 170 and a lighting device 180.

As another example, a display device (not shown) may be disposed at the door 70 as an electronic component. The display device may provide information on the home appliance to the user. The user may input an operation command through the display device.

The image acquisition module 100 or a part of the display device may be provided inside the door 70. In this case, the electronic component such as the image acquisition module 100 or the display device may exchange an electric signal with a main controller provided in the main body 10 of the home appliance (see FIG. 2) or may be connected to the main body 10 by wire for power supply. Hereinafter, it is described as an example that the electronic component disposed in the door 70 is the image acquisition module 100.

In the present embodiment, the home appliance may be a built-in type home appliance. For example, the home appliance may be a cooking appliance installed in a built-in method. Referring to FIG. 1, the cooking appliance of the present embodiment may be arranged in a kitchen furniture 1 and thus only the front surface of the cooking appliance may be exposed to the front. In this case, a door 70 and a manipulator 15 may be included on the front surface of the cooking appliance. Reference numeral 16 denotes a display part exposed on the front surface of the manipulator 15. The image acquisition module 100 and a guide device 200 described above may be disposed inside the door 70.

Referring to FIG. 1, the kitchen furniture 1 may include a lower structure 2, a rear portion 3, an upper portion 4, and a side portion 5. The home appliance may be surrounded by the lower structure 2, the rear portion 3, the upper portion 4, and the side portion 5, and only the front surface may be exposed forward. Since an area exposed to the front of the home appliance is small, maintenance of the electronic component may also be performed in a narrow space.

FIG. 2 shows only the home appliance after the kitchen furniture 1 is removed. A guide mounting part CM may be provided on the door 70 constituting the home appliance. The guide mounting part CM may be provided on the surface of the door 70 or may be provided inside the door 70. A module guide, which will be described below, may be disposed on the guide mounting part CM.

A wire may be connected to the electronic component. The wire may include a main wire disposed inside the home appliance main body 10. The wire may include a door wire W2 connected to the image acquisition module 100 disposed inside the door 70. The wires may be electrically connected to each other to transmit signals and supply power. The main wire is referred to as a mating wire W1.

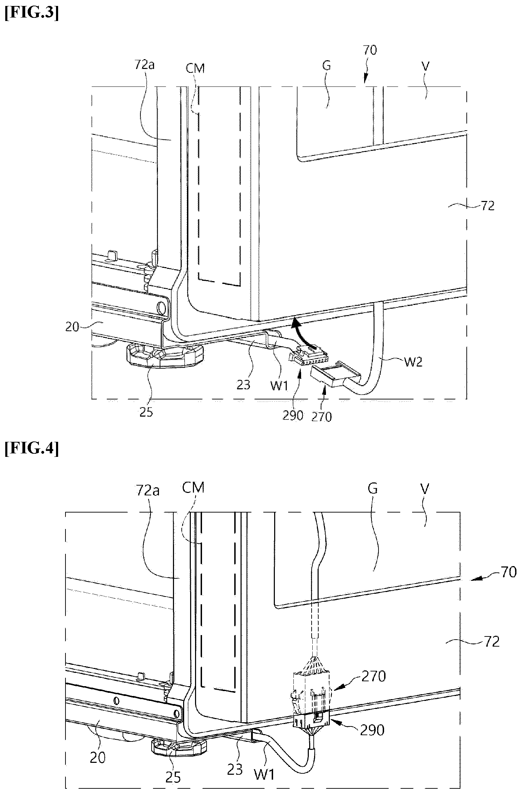

Referring to FIG. 3, the mating wire W1 and the door wire W2 may be electrically connected to each other through connectors 270 and 290. The connectors 270 and 290 may include a door connector 270 disposed in the door 70 and a main connector disposed on the main body 10. The door connector 270 may be assembled with and electrically connected to the main connector. Alternatively, the door connector 270 may be assembled with an external connection connector instead of the main connector. Here, both the main connector and the connection connector will be referred to as the mating connector 290.

In FIG. 3, reference numeral 20 denotes a side frame 20 supporting a lower end of the main body 10 of the home appliance. A wiring pipe 23 guiding a mounting direction of the main wire W1 may be provided in the side frame 20. The main wire W1 may be disposed on a lower side surface of the main body 10 along the wiring pipe 23. Reference numeral 25 denotes a seating leg for adjusting the height of the main body 10.

FIGS. 3 to FIG. 5 sequentially illustrate a state in which the door connector 270 disposed on the guide mounting part CM is assembled with the mating connector 290 in a state in which the door connector 270 is pulled out to the outside of the door 70, and the two assembled connectors are disposed on the guide mounting part CM. When looking at a process in which the door connector 270 and the mating connector 290 are assembled, first, the door connector 270 may be pulled out from the guide mounting part CM. Here, pulling out means that the door connector 270 is pulled out of the outside of the door 70. In the present embodiment, the door connector 270 may be pulled out to the lower portion of the door 70.

The door connector 270 may be assembled with the mating connector 290 protruding to the outside of the wiring pipe 23. When the door connector 270 and the mating connector 290 are assembled with each other, the door wire W2 and the mating wire W1 may be electrically connected to each other. The door wire W2 and the mating wire W1 each have a certain spare length, so the door connector 270 and the mating connector 290 may be freely assembled. However, the door connector 270 and the mating connector 290 may be stored in the guide mounting part CM after being assembled with each other. In this process, since the mating wire W1 is pulled into the guide mounting part CM and there is no spare length, the exposed portion of the mating wire W1 stretching outside the door 70 due to the spare length may be reduced. The structure will be described below.

When the door connector 270 and the mating connector290 are assembled with each other, they may be stored in the direction of the arrow of FIG. 3. FIG. 4 shows a state in which the door connector 270 and the mating connector 290 are inserted into the entrance of the door 70 in the assembled state. Here, the entrance of the door 70 means a body opening 73a to be described below.

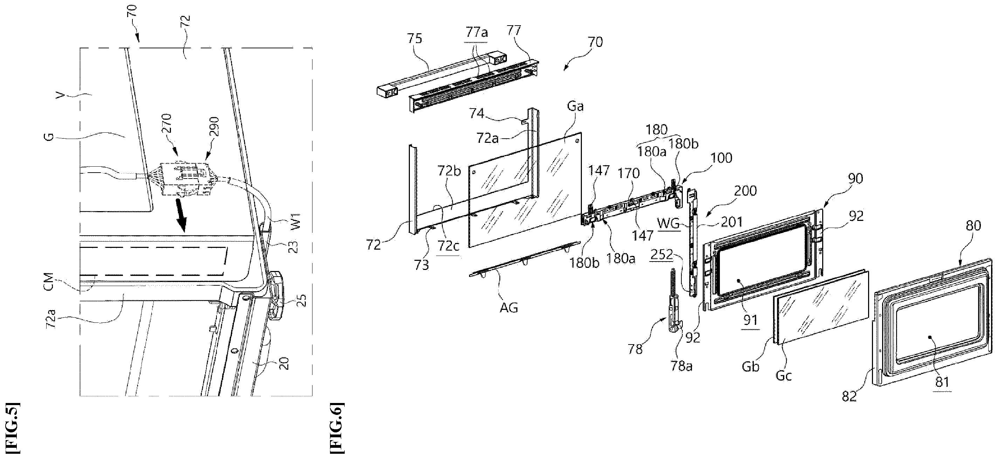

FIG. 5 illustrates a state in which the door connector 270 and the mating connector 290 are further inserted into the door 70. In this state, when the door connector 270 and the mating connector 290 move to the left based on the drawing, they may be disposed in the guide mounting part CM. A guide device 200, which will be described below, may be disposed on the guide mounting part CM. The door connector 270, the mating connector 290, and both the door wire W2 and the mating wire W1 may be disposed in the guide device 200. The door connector 270, the mating connector 290, and the door wire W2 and the mating wire W1 disposed in the guide device 200 may constitute a guide module.

FIG. 6 illustrates the structure of a door body constituting the door 70. The door body may include door frame 72, 77, 80, and 90 and a door panel G. The door frame 72, 77, 80, and 90 and the door panel G may be coupled together to form an approximately thin hexahedral structure.

The door frame, identified by numerals 72, 77, 80, and 90 may include a plurality of frame components. In the present embodiment, the door frame may include a front frame part 72, a rear frame part 80, an inner frame part 90, and an upper frame part 77. They may be coupled together to form a unified door frame. Here, the 'front' is based on the front side of the main door 70.

The front frame part 72 is positioned in front of the door frame 72, 77, 80, and 90. More precisely, the front frame part 72 may form the front skeleton of the door frame structure. The front frame part 72 may have an approximately rectangular in shape. The front frame part 72 has a rectangular frame shape in which the upper and lower portions are opened upward and downward, respectively. A pair of front side bodies 72a may be provided on both sides of the front frame part 72. The pair of front side bodies 72a may be erected in the vertical direction

The front side body 72a may be viewed as an edge part forming the edge of the door body. The front side body 72a may form both edges of the door body. As another example, the front side body 72a may have an approximately rectangular frame shape, and may include both edges and upper and lower edges.

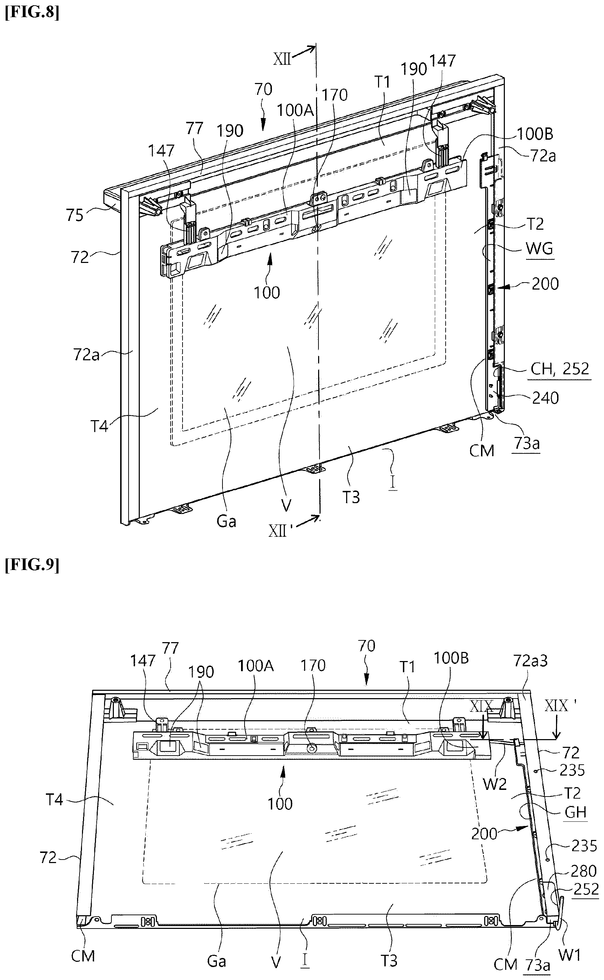

Referring to FIG. 8, a front lower plate 72b may be connected between the pair of front side bodies 72a. The front side body 72a and the front lower plate 72b are connected to each other to form an approximately 'U' shape.

A front opening 72c may be formed between the front side body 72a and the front lower plate 72b. The front opening 72c may be an empty space that is opened in the front-rear direction. A front panel Ga constituting the door panel G (see FIG. 5) may be disposed on the front opening 72c. The front panel Ga may fill the opened portion of the front opening 72c.

More precisely, the area of the door panel G may be larger than the area of the front opening 72c, such that the front panel Ga may be stacked on a portion of the front side body 72a and a portion of the front lower plate 72b. respectively. The front side body 72a and the front panel Ga, the front lower plate 72b and the front panel Ga may be coupled to each other by an adhesive, an adhesive tape, or the like.

The front panel Ga may be disposed on one side of the front side body 72a of the front frame part 72. A second handle 75 may be disposed on the opposite side of the front side body 72a. In this case, a separate fastener (not shown) may pass through the front side body 72a and the front panel Ga and then be fastened to the second handle 75. The structure of the front side body 72a will be described again below.

A lower frame part 73 may be provided at a lower end of the front frame part 72. The lower frame part 73 may be a part of the front frame part 72 or may be separate from the front frame part 72. The lower frame part 73 may be bent at a lower end of the front frame part 72. The body opening 73a may be formed in the lower frame part 73.

The image acquisition module 100 may be disposed behind the front panel Ga. In this case, the image acquisition module 100 may be adhered to the rear surface of the front panel Ga. The image acquisition module 100 may include an image sensing device 170. The image acquisition module 100 may include a plurality of lighting devices 180 together with the image sensing device 170. As another example, either the image sensing device 170 or the lighting devices 180 may be omitted.

Among insulating panels Gb and Gc forming a rear surface of the door 70, the rear panel Gc may be exposed backward. A viewing part V may be provided on the rear panel Gc. Although no reference numeral is given, the viewing part V may also be provided on an inner panel Gb that is not exposed to the outside of the door 70 among the insulating panels Gb and Gc.

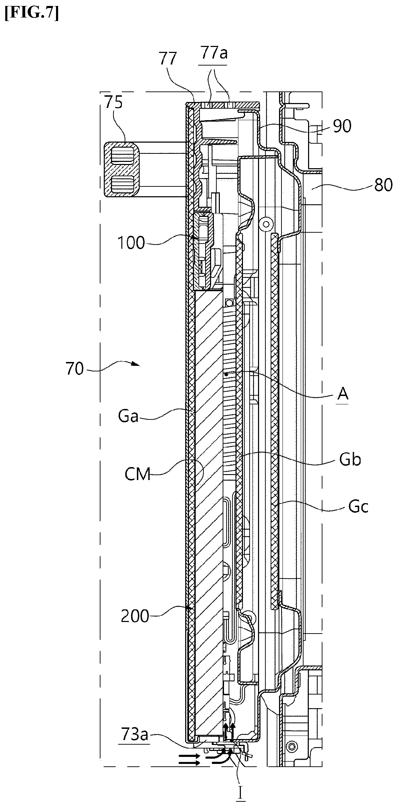

Referring to FIG. 7, the door panel G may include a total of three panels. The three panels may consist of a front panel Ga disposed at the most front side, an inner panel Gb disposed at the inside of the door 70, and a rear panel Gc disposed at the most rear side. Among them, the front panel Ga may be exposed toward the front side (left side based on FIG. 7). The rear panel Gc may be exposed toward the rear side (right side based on FIG. 7).

An installation area T1-T4 may be provided between the front panel Ga and the insulating panels Gb and Gc. The installation area T1-T4 is provided in an empty space between the front panel Ga and the insulating panels Gb and Gc. A location of the installation area T1-T4 is shown in FIG. 8. The installation area T1-T4 may be an area where the image acquisition module 100 and the guide device 200 are disposed. The installation area T1-T4 may be an area where the image acquisition module 100 and the guide device 200 are disposed.

As another example, the insulating panels Gb and Gc may be omitted, and the installation area T1-T4 may be provided between the front panel Ga and the door frames 72, 77, 80, and 90. As another example, the door panel G may be omitted, and the installation area T1-T4 may be provided inside the door frames 72, 77, 80, and 90, or may be provided on an outer surface of the door frames 72, 77, 80, and 90.

The guide device 200 may be disposed between a plurality of panels. For example, the guide device 200 may be disposed between the front panel Ga and the inner panel Gb among the insulating panels Gb and Gc.

As another example, the guide device 200 may be disposed between the front panel Ga and the door frames 72, 77, 80, and 90. As another example, the guide device 200 may deviate from the door panel G and may be disposed on the door frames 72, 77, 80, and 90.

Referring to FIG. 8, the image acquisition module 100 may include the image sensing device 170. The lighting device 180 may be provided in the image acquisition module 100. In FIG. 8, a lighting cover 190 covering the lighting device 180 is illustrated.

A main unit 100A that is a part of the image acquisition module 100 may be disposed in a first installation area (T1, T3). A part of a connection unit 100B that is the remaining part of the image acquisition module 100 may be disposed in the first installation area (T1, T3) or a second installation area (T2, T4). The image acquisition module 100 and the guide device 200 may be electrically connected to each other through the door wire W2. In the present embodiment, the guide device 200 may be disposed in the second installation area (T2, T4). Reference numeral 147 denotes a bracket for fixing the image acquisition module 100.

The guide device 200 may be disposed on the door body. The guide device 200 may be disposed on the door body to support the door wire W2 and a connector assembly C. Accordingly, the door wire W2 may be disposed along a predetermined path. The connector assembly C may maintain a state of being fixed to a designated position of the door 70 through the guide device 200 .

A guide mounting part CM may be provided in the installation area (T1 to T4). The guide mounting part CM may be a portion where the guide device 200 is disposed. The guide mounting part CM may be provided at an edge of the door body. Referring to FIG. 8, the guide mounting part CM may be provided at an edge close to the side surface of the door body.

The door body may include a front part constituting the front surface of the door body and an edge part constituting the edge of the door body. The front part may be the front panel Ga. The edge part may be the door frames 72, 77, 80, and 90. The guide device 200 may be disposed on the guide mounting part CM provided between the front part and the edge part. As shown in FIGS. 8 and 9, the guide mounting part CM may be provided between the front panel Ga serving as the front part and the front side body 72a serving as the edge part. When the guide mounting part CM is provided between the front part and the edge part in this way, the wires disposed on the guide mounting part CM and the connector assembly C may not be exposed to the center of the door body, for example, the viewing part.

For another example, the guide mounting part CM may be disposed on surfaces of the door frames 72, 77, 80, and 90. For example, the guide mounting part CM may be disposed outside the rear frame part 80 to be described later. For another example, the guide mounting part CM may be disposed between the rear frame part 80 and the inner frame part 90 to be described later.

The lower frame part 73 may be provided on a lower end of the door 70. The body opening 73a of the guide mounting part CM may be opened in the lower frame part 73. As shown in FIG. 9, the body opening 73a may be formed by vertically passing through the lower frame part 73. The body opening 73a may be viewed as apart of the air inlets I, which are inlets of a plurality of cooling passages A (see FIG. 7) open to the lower frame part 73. An air guide AG (see FIG. 6) coupled to the lower frame part 73 may form the air inlet I.

Meanwhile, the upper frame part 77 may be disposed above the front opening 72c. The upper frame part 77 may be coupled to an upper portion of the front frame part 72, more specifically, an upper end of the pair of front side bodies 72a. The upper frame part 77 may cover a portion of the upper end of the rear surface of the front panel Ga. The image acquisition module 100 to be described below may be fixed to the upper frame part 77.

A frame outlet 77a may be opened at the upper frame part 77. The frame outlet 77a may be an outlet through which air passing through the cooling passage A formed inside the door 70 is discharged to the outside. The frame outlet 77a may be connected to the installation area T1-T4 as described below.

In FIG. 6, reference numeral 78 denotes a door hinge for connecting the door body to the main body 10. A hinge hanger arm 78a protrudes from the door hinge 78 and may be connected to the main body 10 of the home appliance.

The front frame part 72 may be disposed on the front side with the door panel G in between. The inner frame part 90 and the rear frame part 80 may be disposed on the rear side of the door panel G. The inner frame part 90 and the rear frame part 80 may be spaced apart from each other to (i) create an insulating space therebetween, and (ii) fix the insulating panels Gb and Gc. The inner frame part 90 may be disposed between the rear frame part 80 and the front frame part 72 so as not to be exposed to the outside. As another example, either the inner frame part 90 or the rear frame part 80 may be omitted. As another example, the inner frame part 90 and the rear frame part 80 may be integrally formed with the front frame part 70. Reference numerals 82 and 92 indicate a rear side body 82 and an inner side body 92 constituting a side surface of the door body, respectively.

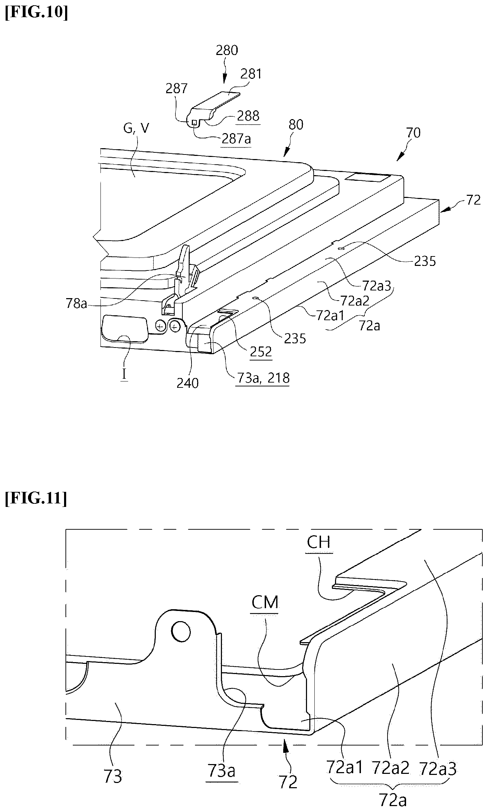

Referring to FIGS. 10 and 11, the front side body 72a may have an approximately "⊏" shaped structure. The front side body 72a may include a first plate 72a1 constituting a first surface at an edge of the door body. The front side body 72a may include a second plate 72a2 constituting the second surface bent from the first surface. The front side body 72a may include a third plate 72a3 bent from the second surface and constituting a third surface facing the first surface. The first plate 72a1, the second plate 72a2, and the third plate 72a3 may form an approximately "⊏"shaped cross-sectional structure.

The mounting inlet may be opened between the first plate 72a1 and the third plate 72a3 in a direction facing the second plate 72a2. The mounting inlet may be a portion at which the first plate 72a1, the second plate 72a2, and the third plate 72a3 are not provided. The guide device 200 may be arranged between the first plate 72a1 and the third plate 72a3 through the mounting inlet.

An open portion may be formed in a portion of the third plate 72a3. As shown in FIG. 11, a portion of the third plate 72a3 may be opened in a vertical direction based on the drawing, such that a guide exposure part CH may be formed. The guide exposure part CH may be provided at a position corresponding to the connector exposure part 252 of the guide device 200 to be described below. When the guide device 200 is disposed on the guide mounting part CM, the guide exposure part CH and the connector exposure part 252 are connected to each other to expose the connector holder 240 to the outside. The operator may store the connector assembly C in the exposed connector holder 240 or take it out from the exposed connector holder 240. FIG. 10 illustrates a state in which the guide exposure part CH and the guide cover 280 covering the connector exposure part 252 are separated.

Surfaces of the guide device 200 may be in close contact with two or more different surfaces of the door body, respectively. For example, three different surfaces of the guide device 200 may be in close contact with the first plate 72a1, the second plate 72a2, and the third plate 72a3. As another example, two surfaces of the guide device 200 may be in close contact with the first plate 72a1 and the third plate 72a3, respectively.

The guide device 200 may be configured to face two or more different surfaces of the door body. When the guide device 200 faces two or more different surfaces of the door body, at least two or more surfaces of the guide device 200 may be surrounded by the door body.

As shown in FIG. 10, when the guide device 200 is arranged inside the front side body 72a and assembly of the door body is completed, most of the guide device 200 may be covered by the door body. The guide device 200 may be exposed through the body opening 73a of the lower frame part 73 and the guide exposure part CH. In this case, the body opening 73a may be connected to a guide opening 218 and a cover opening 288 to be described below. The mating wire W1 may extend outward through the body opening 73a.

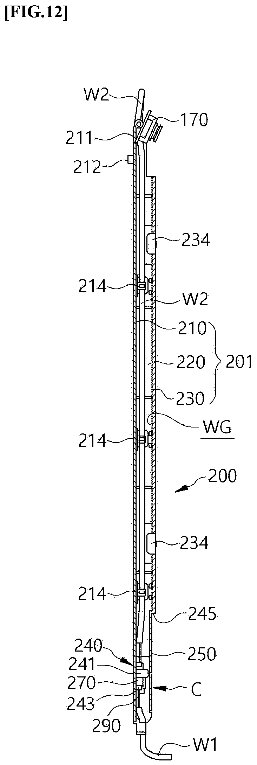

Referring to FIG. 12, the image sensing device 170 of the image acquisition module 100 is illustrated with the connection assembly, the door wire W2 connecting the door connector 270 and the image sensing device 170, and the mating wire W1 connected to the mating connector 290. Also, the guide device 200 is illustrated in FIG. 12. In the present embodiment, an electronic component such as the image sensing device 170 is arranged at an upper portion of the door body, and the guide device 200 is arranged between the upper and lower portions of the door body. As another example, the guide device 200 may be disposed at a lower portion of the door 70 in a direction parallel to the electronic component.

The guide device 200 may be disposed on the guide mounting part CM. The guide device 200 may store the door wire W2 and the door connector 270. The guide device 200 may store the mating wire W1 and the mating connector 290. Since the guide device 200 is fixed to the guide mounting part CM, the door wire W2, the door connector 270, the mating wire W1, and the mating connector 290 may also be fixed to the guide mounting part CM.

The guide mounting part CM may be provided in the installation area T1 to T4. Since the installation area T1 to T4 is arranged in the edge of the door body, the guide mounting part CM may also be provided in the edge of the door body. If the viewing part V is provided at the center of the door body, the guide mounting part CM may be arranged outside the viewing part V.

The guide device 200 may be arranged on the guide mounting part CM while sliding along the door body. The guide device 200 may be elastically supported on the guide mounting part CM without a separate fastener.

When the guide device 200 is disposed on the guide mounting part CM, the guide device 200 may move while sliding in a first direction. Here, the first direction is a direction moving along the surface of the front panel Ga. The guide device 200 disposed on the guide mounting part CM may be supported by the door body in a second direction. The second direction may be different from the first direction and may be a direction orthogonal to the first direction. The guide device 200 may be elastically supported by the door body in the second direction by an elastic support part. Such a structure will be described in detail below.

The guide device 200 may be provided with a guide path GH extending along the longitudinal direction of the guide device 200. The door wire W2 may be stored in the guide path GH. The connector holder 240 may be provided in the guide path GH. The door connector 270 connected to the door wire W2 and the mating connector 290 may be secured in the connector holder 240. FIG. 12 shows a state in which the door wire W2 is arranged in a vertical direction and the connector assembly C is disposed below the door wire W2. And the mating wire W1 connected to the mating connector 290 may extend outward through one end of the guide device 200 corresponding to the opposite side of the image sensing device 170.

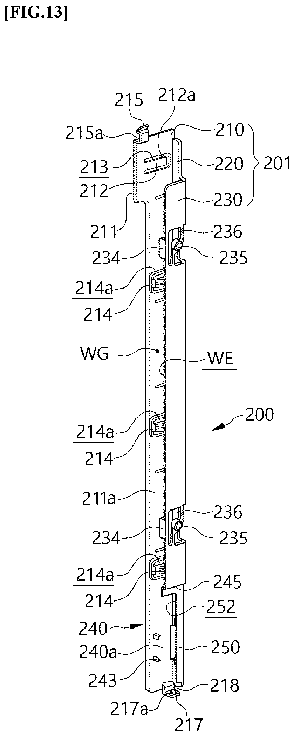

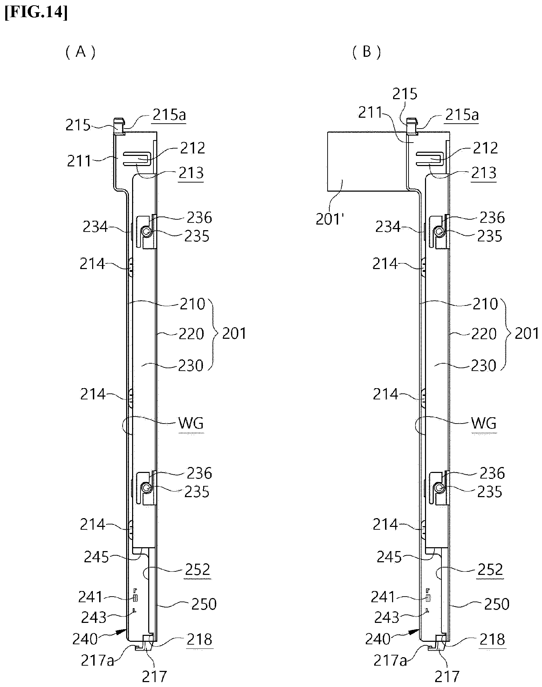

Referring to FIGS. 13 and 14A, the guide device 200 may have a guide housing 201 having an elongated structure extending in one direction. The guide housing 201 may be formed to have a length sufficient to store the door wire W2 corresponding to the extended length of the door wire W2. A continuous guide path WH may be formed in the guide housing 201 to guide the path of the door wire W2.

As another example, the guide device 200 may include a body extending in two different directions. For example, as shown in FIG. 14B, the guide device 200 may include an extension body 201' toward the image acquisition module 100. The guide housing 201 may be connected to one end of the extension body 201'.

Referring to FIG. 13, the guide housing 201 may have the guide path GH therein. The guide housing 201 may have a structure surrounding the guide path GH. A portion of the guide path GH is opened to the outside, and the door wire W2 may be stored through the opened portion. The open portion may be a wire entrance WE to be described later.

Looking at the structure of the guide housing 201 in detail, the guide housing 201 may include a base body 210. The base body 210 may have an approximately flat plate structure. The base body 210 may be seated on the first plate 72a1 of the front side body 72a constituting the door body. The base body 210 may be in close contact with and supported by the first plate 72a1.

A wire seating surface 211a may be formed on the surface of the base body 210. The wire seating surface 211a may be viewed as one surface forming the guide path GH. The wire seating surface 211a may be provided with the connector holder 240 to be described below. The connector holder 240 may protrude from the surface of the base body 210. The structure of the connector holder 240 will be described again below.

A side body 220 may be provided at one end of the base body 210. The side body 220 may be erected at one end of the base body 210. Here, the erection direction is based on the front-rear direction (X-axis direction in FIG. 1) of the door 70. Like the base body 210, the side body 220 may have a flat plate structure. The side body 220 may be arranged to face the second plate 72a2 of the front side body 72a constituting the door body. The side body 220 may be in close contact with or spaced apart from the second plate 72a2.

A cover body 230 may be connected to the side body 220. The cover body 230 may extend from the side body 220 in a direction different from that of the side body 220. In the present embodiment, the cover body 230 may be provided to face the base body 210. Thus, the guide housing 201 may have an approximately "⊏"shaped cross section.

The guide path GH may be formed between the base body 210, the side body 220, and the cover body 230. A plurality of surfaces of the guide path GH may surround the door wire W2 in at least three different directions. The surface of the base body 210 may surround the lower portion of the door wire W2. The surface of the side body 220 may surround the side portion of the door wire W2. The surface of the cover body 230 may surround the upper portion of the door wire W2.

The guide path GH may form a continuous space along the longitudinal direction of the guide housing 201. The guide path GH may align the door wire W2 and the mating wire W1. The door wire W2 and the mating wire W1 may be aligned along a direction in which the guide path GH extends.

One side of the guide path GH may be opened to form the wire entrance WE. The door wire W2 and the mating wire W1 may be inserted through the wire entrance WE. The connector assembly C may be inserted through the wire entrance WE. Like the guide path GH, the wire entrance WE may be continuously formed along the longitudinal direction of the guide housing 201.

Three openings may be opened in different directions in the guide device 200. The three openings may include (i) two openings opened at both ends of the guide path GH, respectively, and (ii) the wire entrance WE. One end of the door wire W2 connected to the electronic component may be stored through the opening opened at one end of the guide path GH. The opening opened at the other end of the guide path GH becomes the guide opening 218, and may be an outlet through which the mating wire W1 extends to the outside. The wire entrance WE may be opened in a direction orthogonal to the openings opened at both ends of the guide path GH, respectively. The wire entrance WE may connect the openings provided at both ends of the guide path GH.

A portion of the guide path GH is opened to the outside, and the door wire W2 may be stored through the opened portion. The open portion may be a wire entrance WE.

An extension board 211 may be provided at one end of the guide housing 201. The extension board 211 may be provided at one end of the guide housing 201 in a direction of increasing the width. The extension board 211 may increase the area of the base body 210. The extension board 211 may be provided at one end of the guide housing 201 into which the door wire W2 is inserted.

A guide leg 212 may be provided on the guide housing 201. The guide leg 212 may protrude from the guide housing 201 toward the surface of the door body. More precisely, the guide leg 212 may protrude toward the surface of the front side body 72a. In the present embodiment, the guide leg 212 may be in close contact with the first plate 72a1 of the front side body 72a.

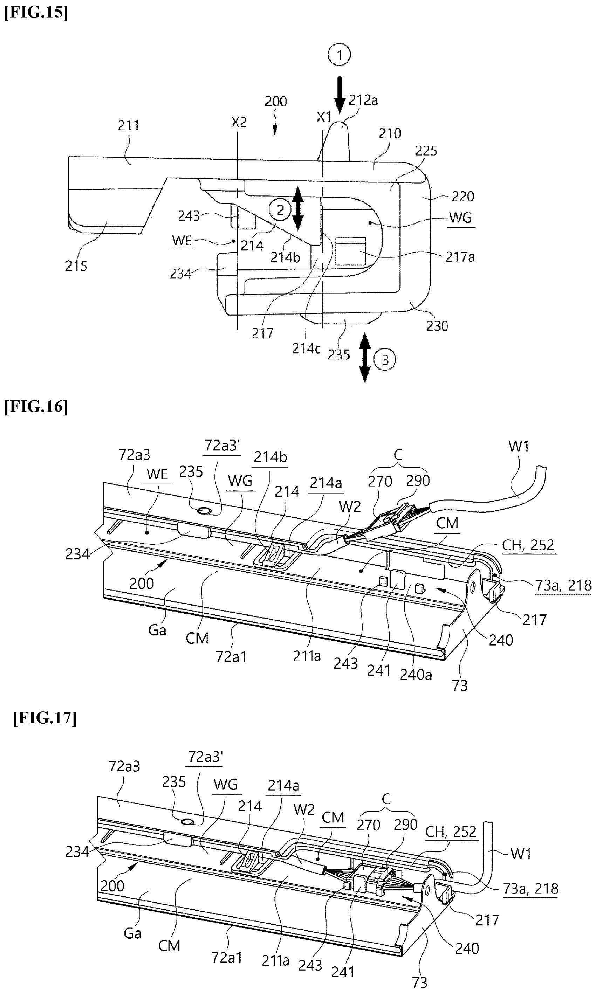

The guide leg 212 may be provided with a leg protrusion 212a protruding in the direction of the first plate 72a1 of the front side body 72a. A deformation slit 213 may be opened in the guide housing 201 around the guide leg 212. The deformation slit 213 may allow the guide leg 212 to be elastically deformed in the direction of the guide path GH (the direction of arrow 1 in FIG. 15). The guide leg 212 may have a kind of cantilever structure by the deformation slit 213. As another example, the guide leg 212 may not be elastically deformed and may simply have a structure protruding in the direction of the first plate 72a1 of the front side body 72a.

The guide leg 212 may constitute an elastic support part together with an elastic support protrusion 235 to be described later. The elastic support part may support the guide device 200 on the door body in the second direction. The guide leg 212 and the elastic support protrusion 235 may support the guide device 200 while being elastically deformed in opposite directions.

The guide leg 212 may elastically support the guide device 200 in the vertical direction (the X-axis direction of FIG. 1) through elastic deformation. The elastic support protrusion 235 constituting the elastic support part may elastically support the guide device 200 in front and rear/left directions (the Y-axis and Z-axis directions of FIG. 1). Accordingly, the guide device 200 may be supported in all directions to stably maintain a fixed state to the door body.

The guide leg 212 may be arranged on an extension board 211 of the guide housing 201. Since the extension board 211 has a relatively large area in the guide housing 201, the length of the guide leg 212 may also be lengthened. A connector holder 240 may be arranged in the guide housing 201 corresponding to the opposite side of the guide leg 212.

A wire holder 214 may be provided in the guide housing 201. The wire holder 214 may be provided in a direction in which the wire entrance WE is narrowed in the guide housing 201. The wire holder 214 may prevent the door wire W2 from being separated from the guide path GH. The door wire W2 may be stored between the wire holder 214 and the surface of the guide housing 201. A plurality of wire holders 214 may be disposed along the longitudinal direction of the guide housing 201.

Referring to FIG. 16, the wire holder 214 may protrude from the base body 210. The base body 210 may be provided with a holder slit 214a around the wire holder 214. The wire holder 214 may be elastically deformed in a direction of widening the guide path GH through the holder slit 214a. In the present embodiment, the wire holder 214 may be elastically deformed in a direction of narrowing or widening the guide path GH (an arrow 2 in FIG. 15).

The wire holder 214 may include a guide surface 214b which is obliquely extended toward the wire entrance WE. When the door wire W2 is stored into the guide path GH, the surface of the door wire W2 may cross over the guide surface 214b. A support surface 214c may be connected to one end of the guide surface 214b. The support surface 214c may be provided in a direction that stands up from the surface of the base body 210. The door wire W2 stored in the guide path GH may be caught by the support surface 214c and not allowed to deviate.

Referring to FIG. 13, a switching holder 215 may be provided in the guide housing 201. The switching holder 215 may protrude from one end of the guide housing 201. The switching holder 215 may have a cantilever structure and may be elastically deformed. The switching holder 215 supports the door wire W2 extended from the image acquisition module 100 so as to switch the extension direction of the door wire W2 into the guide path GH. A switching groove 215a is opened in the switching holder to surround the door wire W2. In the present embodiment, the switching holder 215 is provided at the upper end of the guide housing 201 with reference to FIG. 13.

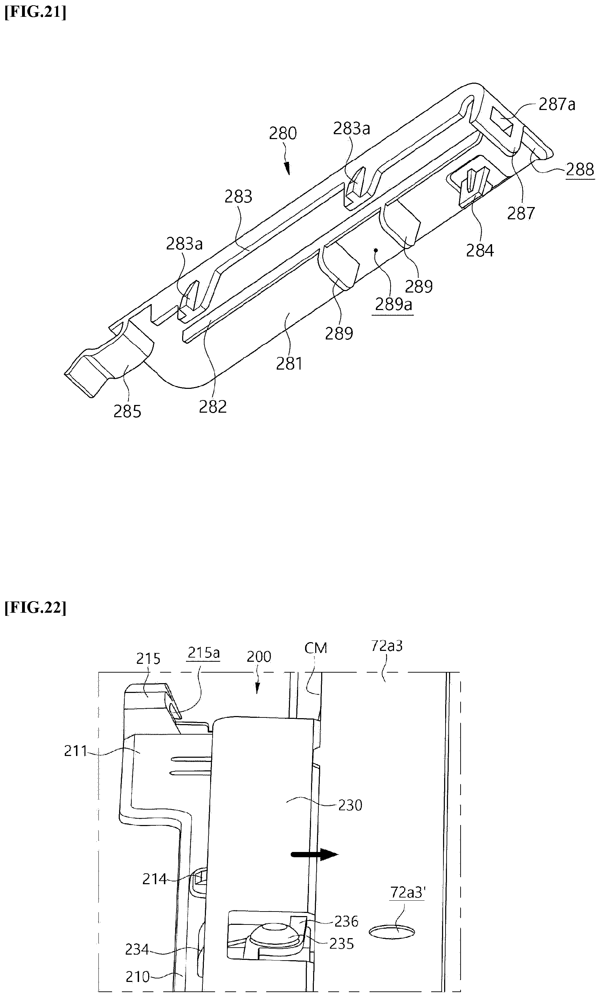

A hanging hook 217 may be provided on an opposite side of the switching holder 215 in the guide housing 201. The hanging hook 217 may fix the guide cover 280. The hanging hook 217 may be provided at a position adjacent to the guide opening 218. It may be seen that the hanging hook 217 forms one edge of the guide opening 218. The hook protrusion 217a may be provided on the hanging hook 217. The hook protrusion 217a may be fitted into a hook fastening hole 287a (see FIG. 21) of the guide cover 280.

The guide housing 201 may be provided with a wire catching protrusion 234. The wire catching protrusion 234 may protrude in a direction of narrowing the wire entrance WE. The wire catching protrusion 234 may prevent the door wire W2, stored in the guide path GH, from deviating. A plurality of wire catching protrusions 234 may be provided to be spaced apart from each other in the longitudinal direction of the guide housing 201.

Referring to FIGS. 15 and 16, the wire catching protrusion 234 may be provided at an edge of the wire entrance WE. The wire holder 214 may be arranged to be spaced apart from the wire catching protrusion 234 in the center direction of the guide path GH formed in the guide housing 201. It may be seen that the wire catching protrusion 234 is arranged outside the guide path GH than the wire holder 214. In FIG. 15, X1 indicates a position where the door wire W2 is caught on the support surface 214c of the wire holder 214. X2 indicates a position where the door wire W2 is caught on the wire catching protrusion 234. Accordingly, the wire holder 214 and the wire catching protrusion 234 may prevent the door wire W2 from deviating from the guide path GH at different positions.

The wire holder 214 and the wire catching protrusion 234 may protrude in opposite directions. Referring to FIG. 15, the wire holder 214 protrudes downward, and the wire catching protrusion 234 protrudes upward. The wire holder 214 and the wire catching protrusion 234 protruding in opposite directions may further reduce a width of the wire entrance WE, thereby effectively preventing the door wire W2 from deviating.

An elastic support protrusion 235 may be provided on the guide housing 201. The elastic support protrusion 235 may be provided on the cover body 230 of the guide housing 201. The elastic support protrusion 235 may protrude further outward from the guide path GH than the surface of the cover body 230.

The elastic support protrusion 235 may be connected to the cover body 230 through a protrusion bridge 236. The elastic support protrusion 235 may be elastically deformed in the height direction (the arrow 3 in FIG. 15) of the guide path GH by the protrusion bridge 236. The elastic support protrusion 235 may be inserted into the protrusion fastening hole 72a3' opened in the third plate 72a3 through elastic deformation. When the elastic support protrusion 235 is inserted into the protrusion fastening hole 72a3', the guide device 200 may be maintained in a state of being disposed on the guide mounting part CM without being separated from the guide mounting part CM.

As shown in FIGS. 13 and 14, a plurality of elastic support protrusions 235 may be arranged on the guide housing 201 to be spaced apart from each other. The plurality of elastic support protrusions 235 may fix the guide device 200 to the guide mounting part CM at different positions.

The guide housing 201 may be provided with a connector holder 240. The connector holder 240 may be arranged inside the guide housing 201 and, more specifically, inside the guide path GH. The connector holder 240 may be viewed as a part of the guide housing 201. The connector holder 240 may serve to fix the connector assembly C to the guide device 200. The connector holder 240 may be arranged closer to the other end of the guide device 200 provided with the hanging hook 217 than one end of the guide device 200 provided with the switching holder 215. The connector holder 240 may be arranged under the door body. Thus, accessibility to the connector holder 240 from the lower portion of the door body may be improved.

The connector holder 240 may support the door connector 270 or the mating connector 290 coupled to the door connector 270. The connector holder 240 may hang at least one of the door connector 270 and the mating connector 290 so that the connector assembly C is fixed in the guide path GH.

The connector holder 240 may be provided with connector fixing arms 241 and 243 protruding from the surface of the guide path GH. In FIG. 16, the connector fixing arms 241 and 243 may protrude from the surface (first surface) of the wire seating surface 211a toward the connector exposure part 252. The connector fixing arms 241 and 243 may form a connector seating surface 240a on which the door connector 270 is seated between the facing surface (second surface) of the guide path GH. Here, the surface of the guide device 200 facing the connector fixing arms 241 and 243 may be the surface of the side body 220.

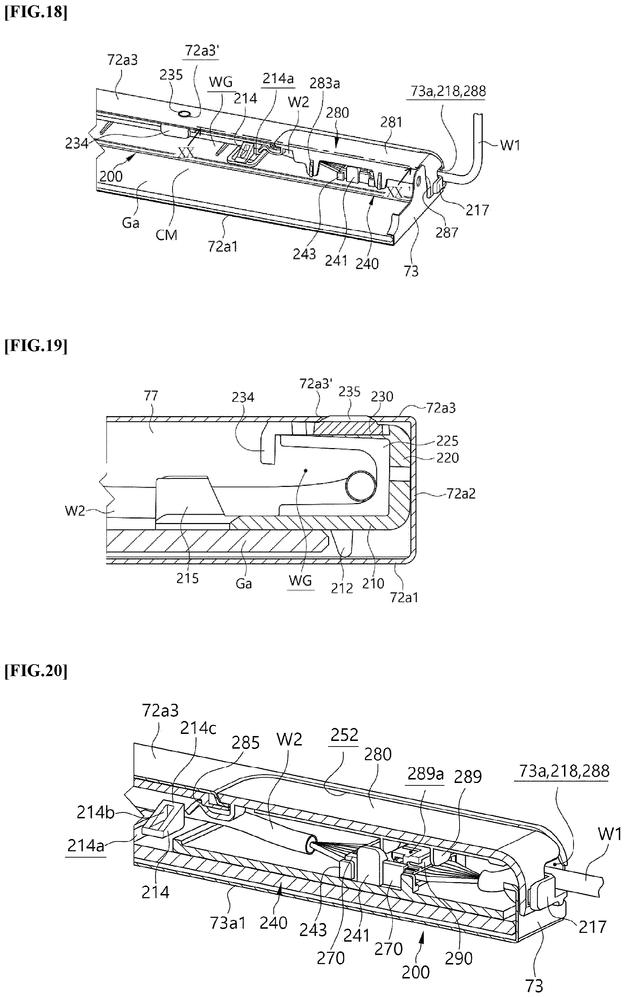

The connector fixing arms 241 and 243 may support both side surfaces of the connector assembly C together with the connector holder 289 provided in the guide cover 280. Referring to FIG. 20, the connector holder 289 protrudes from the opposite side (upper side based on the drawing) of the connector fixing arms 241 and 243, so that the connector holder 289 may support the mating connector 290.

The connector fixing arms 241 and 243 may include a first fixing arm 241 for hanging and fixing one end of the door connector 270. The connector fixing arms 241 and 243 may include a second fixing arm 243 supporting both ends of the door connector 270. The first fixing arm 241 and the second fixing arm 243 may be arranged to be spaced apart from each other along the longitudinal direction of the guide device 200 in the connector holder 240. The second fixing arm 243 may be arranged on both sides of the first fixing arm 241 interposed therebetween.

As another example, one of the first fixed arm 241 and the second fixed arm 243 may be omitted. As another example, the first fixed arm 241 and the second fixed arm 243 may be disposed on both sides of the connector seating surface 240a, respectively, with the connector seating surface 240a as the center.

A step part 245 may be provided on the connector holder 240. The step part 245 may be provided at one end of the connector holder 240. The connector holder 240 may have a recessed structure in the guide device 200, based on the step part 245. The connector holder 240 may be considered to start from the step part 245. The guide cover 280 may be disposed on an upper portion of the connector holder 240 lowered by the step part 245. The guide cover 280 may form a continuous plane with the cover body 230.

The connector exposure part 252 may be opened in the connector holder 240. The connector exposure part 252 may be provided at a position corresponding to the guide exposure part CH. The connector exposure part 252 has a structure in which a portion of the connector holder 240 is open, and thus may expose the connector seating surface 240a. The guide cover 280 may be coupled to the connector exposure part 252 to shield the connector seating surface 240a.

As another example, the guide cover 280 may be omitted. In this way, the connector exposure part 252 may be maintained in an exposed state at all times. The operator may approach the connector assembly C through the guide exposure part CH and the connector exposure part 252. As another example, not only the guide cover 280 but also the connector exposure part 252 may be omitted. In this case, the connector assembly C may be pulled out of the door 70 through the body opening 73a.

A cover coupling part 250 may be provided on the connector holder 240. The cover coupling part 250 may be disposed to surround the connector exposure part 252. The guide cover 280 may be coupled to the cover coupling part 250. The guide cover 280 may be stacked on the cover coupling part 250. The connector exposure part 252 may be considered to be provided on the cover coupling part 250.

Referring to FIGS. 17 and 18, the appearance before and after assembly of the guide cover 280 is illustrated. When the guide cover 280 is separated from the cover coupling part 250, the connector assembly C may be exposed through the connector exposure part 252. The exposed connector assembly C may be pulled out of the door 70. In contrast, when the guide cover 280 is assembled to the cover coupling part 250, the connector exposure part 252 may be blocked by the guide cover 280, and the connector assembly C may also be shielded.

FIG. 19 illustrates the door wire W2 stored in the guide path GH. As shown, the direction of the door wire W2 may be changed through the switching holder 215. The door wire W2 of which the direction is changed may extend through the guide path GH. In this case, a wire grip 225 may protrude in the inside of the guide path GH in a direction to reduce the cross-sectional area of the guide path GH. The wire grip 225 may be formed in a curved or inclined structure. The wire grip 225 may surround the surface of the door wire W2 so that the door wire W2 is stably stored in the guide path GH.

Referring to FIG. 19, the lower side of the guide device 200 may be supported by the guide leg 212. The guide leg 212 may be disposed outside the front panel Ga. The guide leg 212 may support the guide device 200 through elastic deformation as described above. The guide leg 212 may be supported on the surface of the first plate 72a1.

Referring to FIG. 19, the upper side of the guide device 200 may be supported by the elastic support protrusion 235. The elastic support protrusion 235 may be inserted into the protrusion fastening hole 72a3' opened in the third plate 72a3 while being elastically deformed through a protrusion bridge 236. As a result, the guide device 200 may be supported by the front side body 72a on both sides thereof. In this way, the guide device 200 may not be separated in a direction away from the guide mounting part CM of the front side body 72a (left side direction of FIG. 19) through a mounting inlet.

Referring to FIGS. 20 and 21, when the guide cover280 is described, the guide cover 280 may cover the connector exposure part 252. The guide cover 280 may be assembled with the cover coupling part 250 to cover the connector exposure part 252. The guide cover 280 may be formed separately from the guide device 200. As another example, the guide cover 280 may be provided integrally with the guide device 200. The guide cover 280 may be provided integrally with the guide device 200 through an inj ection hinge. As another example, the guide cover 280 may be maintained in a state of being connected to the guide device 200 through a separate cable.

The frame of the guide cover 280 may be formed by a plate-shaped cover plate 281. The cover plate 281 may have a shape corresponding to that of the connector exposure part 252. A reinforcing rib 282 may be provided on a surface of the cover plate 281. The reinforcing rib 282 may reinforce the strength of the cover plate 281.

A side fence 283 may be provided on a side surface of the cover plate 281. The side fence 283 may be provided in a direction of narrowing the wire entrance WE. Like the wire catching protrusion 234, the side fence 283 may narrow the wire entrance WE to prevent deviation of the door wire W2, the connector assembly C, or the mating wire W1. Reference numeral 283a denotes a reinforcing part for preventing deformation of the side fence 283.

A pull-out guide 284 may protrude from the guide cover 280 in a direction orthogonal to the direction in which the cover opening 288 is opened. The pull-out guide 284 may protrude from the surface of the cover body 230 toward the connector seating surface 240a. The pull-out guide 284 may support one side of the mating wire W1 to guide the mating wire W1 to the cover opening 288. The pull-out guide 284 may be arranged in a position adjacent to the cover opening 288.

One end of the guide cover 280 may be fixed to one edge of the connector exposure part 252. The guide cover 280 may be provided with a cover holder 285 which is hung on one side of the connector exposure part 252. The cover holder 285 may be hung and fixed to one end of the connector exposure part 252. To this end, the cover holder 285 may have a cantilever structure which is elastically deformable. The cover holder 285 may be supported by one end of the connector exposure part 252 through a bent shape.

The opposite side of the cover holder 285 may be coupled to the hanging hook 217 of the guide device 200. A hook assembly piece 287 may be provided on the guide cover 280. A hook fastening hole 287a may pass through the hook assembly piece 287. The hook protrusion 217a of the hanging hook 217 may be fitted into the hook fastening hole 287a. FIG. 20 shows the hanging hook 217 in close contact with the hook assembly piece 287.

A connector holder 289 may protrude from the guide cover 280. The connector holder 289 may protrude from the surface of the guide cover 280 in a direction opposite to the connector fixing arms 241 and 243. The connector holder 289 may support one side of the connector assembly C. The connector holder 289 may be provided in a direction crossing the connector holder 240. In the present embodiment, the connector holder 289 may be configured as a pair. A connector support groove 289a may be formed in a relatively recessed structure between a pair of connector holders 289. A portion of the connector assembly C may be disposed in the connector support groove 289a.

A cover opening 288 may be opened on the guide cover 280. The cover opening 288 may be opened in the extending direction of the guide path GH when the guide cover 280 is assembled to the guide device 200. In the present embodiment, the cover opening 288 may be provided adjacent to the hook assembly piece 287. It may be considered that the hook assembly piece 287 constitutes one side surface of the cover opening 288.

Referring to FIG. 20, the body opening 73a, the guide opening 218, and the cover opening 288 may be opened in the door body, the guide device 200, and the guide cover 280, respectively. The body opening 73a, the guide opening 218, and the cover opening 288 may be connected to each other to form the wire outlet. The mating wire W1 may extend outward through the wire outlet. Here, the outside may mean the main body 10 of the home appliance connected through the wiring pipe 23.

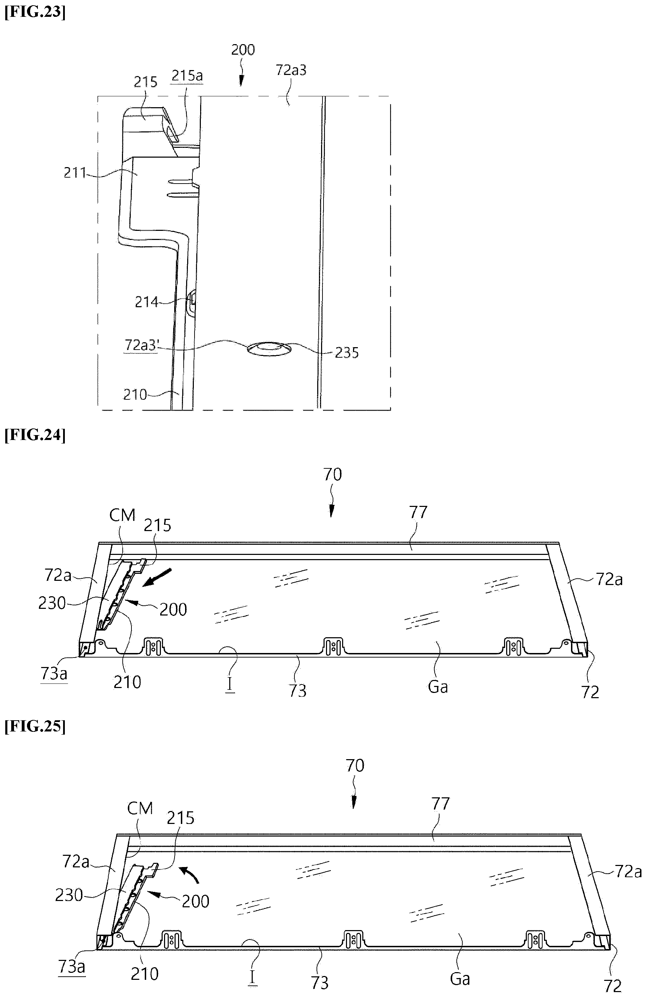

A process in which the guide device 200 is assembled to the door body will be described with reference to FIGS. 22 and 23. The guide device 200 may be mounted on the door body. The guide device 200 may be mounted on a guide mounting part CM provided on the door body. The guide mounting part CM may be provided in the installation area T1-T4. In the present embodiment, the guide mounting part CM is provided in the second installation areas T2 and T4.

The guide mounting part CM may be provided inside the front side body 72a. The guide device 200 may move toward the inside of the guide mounting part CM while sliding along the surface of the door body. Here, the surface of the door body may be the surface of the front panel Ga.

In the process of mounting the guide device 200 to the guide mounting part CM, the guide leg 212 and the elastic support protrusion 235 may be elastically deformed. More precisely, the guide leg 212 and the elastic support protrusion 235 may be elastically deformed in a direction of reducing the height of the guide path GH. Since the height between the guide leg 212 and the elastic support protrusion 235 is higher than the height of the guide mounting part CM, the guide leg 212 and the elastic support protrusion 235 may be elastically deformed. The height of the guide mounting part CM may be the height between the first plate 72a1 and the third plate 72a3.

When the guide device 200 slides in the direction of the arrow of FIG. 22, the elastic support protrusion 235 may be elastically deformed by being pressed by the surface of the third plate 72a3. The elastic support protrusion 235 may be inserted into the protrusion fastening hole 72a3' of the third plate 72a3. When the elastic support protrusion 235 is inserted into the protrusion fastening hole 72a3', the elastic support protrusion 235 may be restored to a circular shape. The elastic support protrusion 235 restored to a circular shape may be caught in the protrusion fastening hole 72a3'. Thus, the guide device 200 may be maintained in a state of being disposed on the guide mounting part CM without being separated from the guide mounting part CM.

At the same time, the guide leg 212 may support the guide device 200 at the opposite side to the elastic support protrusion 235. Referring to FIG. 15, the leg protrusion 212a of the guide leg 212 may be pressed by the first plate 72a1 (in the direction of the arrow 1), thereby elastically supporting the guide device 200. As such, the guide leg 212 and the elastic support protrusion 235 may support the guide device 200 at the opposite sides thereof, respectively. Accordingly, the guide device 200 may be fixed to the door body without the use of a separate fastener.

As another example, the guide leg 212 or the elastic support protrusion 235 may be omitted. As another example, the guide leg 212 may be provided on both sides of the guide device 200 instead of the elastic support protrusion 235.

FIGS. 24 to 30 sequentially show another embodiment of the guide device 200 being mounted on the door body. Detailed description of the same structure as the previous embodiment will be omitted.

Referring to FIG. 24, the guide device 200 may be disposed on the guide mounting part CM arranged opposite to the guide mounting part CM according to the previous embodiment. The guide mounting part CM may be arranged on a left edge of the door body on the basis of the drawing.

In this embodiment, the guide cover 280 is omitted from the guide device 200. The lower end of the guide device 200 is opened, and the opened portion may be connected to the body opening 73a of the door body. The door connector 270 and the mating connector 290 may enter and exit through the body opening 73a connected in this way.

Looking at the process of mounting the guide device 200, the guide device 200 may move in a first direction and be disposed on the guide mounting part CM. The guide device 200 may be supported by the door body in a second direction different from the first direction.

Here, the first direction refers to a direction in which the guide device 200 moves along the surface of the door body. The arrow in FIG. 24 shows a direction in which the guide device 200 is seated on the surface of the door body and moves. The first direction may be a linear direction or a curved direction.

In the second direction, the guide device 200 may be orthogonal to the first direction. The guide device 200 may be elastically supported on the door body in the second direction by an elastic support part. In this embodiment, the guide device 200 may be supported on the door body in the second direction at a plurality of points. When the plurality of elastic support parts are provided, the guide device 200 may be elastically supported on the door body in the second direction at a plurality of points.

As another example, the guide device 200 may be press-fitted into the door body, ultrasonic-welded, or bonded to be supported. As another example, the guide device 200 may be fastened to the guide mounting part CM with a fastener such as a screw.

The guide device 200 may slide in an oblique direction (in the direction of an arrow in FIG. 24), so that one end of the guide device 200 may be first supported by one end of the guide mounting part CM. As shown in FIG. 24, the guide device 200 may be arranged at an oblique angle.

In this state, the guide device 200 may be rotated in a direction of an arrow of FIG. 25. This rotation may be performed in a state where the surface of the guide device 200 is in close contact with the front panel Ga of the door body. When the guide device 200 is rotated, the other end of the guide device 200 may be inserted into the other end of the guide mounting part CM.

As described above, one end of the guide device 200 may be supported by the door body, and the other end of the guide device 200 may be rotated in the first direction with respect to the one end thereof to be mounted on the door body. A fixing end may be provided at one end portion of the guide device to be supported at a first point of the door body. Here, the fixing end indicates a lower end of the guide device with reference to FIG. 24, and the first point may be a surface of the door body adjacent to the body opening 73a.

A rotating end may be provided at the other end portion of the guide device 200. The rotating end may be rotated around the fixing end to be supported by a second point of the door body. Here, the rotating end indicates an upper end of the guide device with reference to FIG. 24, and the second point may be a surface of the guide mounting part CM adjacent to the upper frame part 77. Although not shown in the drawings, the guide leg 212 may be provided at the rotating end.

Although omitted in this embodiment, as another example, an elastic support protrusion elastically deformed in the second direction may be further provided between the fixing end and the rotating end.

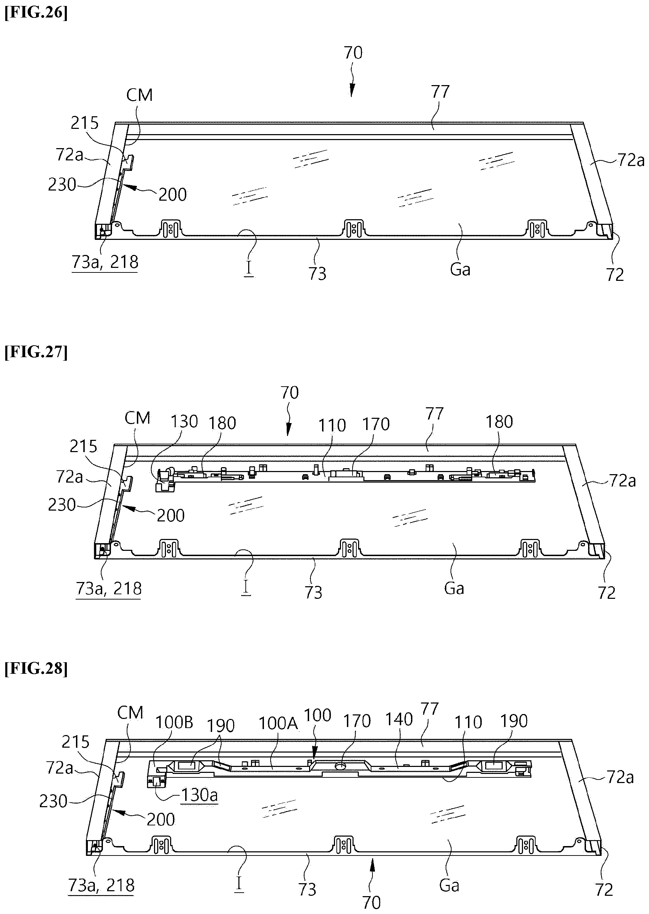

Referring to FIG. 26, a state in which the guide device 200 is stored in the guide mounting part CM is illustrated. When the guide device 200 is stored in the guide mounting part CM, the guide device 200 does not invade the viewing part provided at the center of the front panel Ga. Since the guide device 200 is arranged at the edge of the door body, which is a kind of dead space, it is not necessary to provide a separate space for mounting the guide device 200.

Referring to FIG. 27, the image acquisition module 100, which is an electronic component, may be disposed on the surface of the front panel Ga. More precisely, the first housing 110 constituting the image acquisition module 100 may be disposed on the front panel Ga. In this embodiment, the image acquisition module 100 may be disposed in the first installation areas T1 and T3. The image sensing device 170 and the lighting device 180 may be disposed in the first housing. Reference numeral 130 denotes a first connection body and may guide a storage direction of the door wire W2.

Referring to FIG. 28, a second housing 140 may be assembled with the first housing 110 to complete the assembly of the image acquisition module 100. As illustrated, the image acquisition module 100 may be arranged in a direction different from that of the guide device 200. When the image acquisition module 100 and the guide device 200 are arranged in different directions, the installation area may be utilized as wide as possible. When the image acquisition module 100 and the guide device 200 are arranged in different directions, one end of the image acquisition module 100 and one end of the guide device 200 may be disposed adjacent to each other.

In this case, one end of the guide device 200 may extend to a height higher than or equal to a height at which the electronic component is disposed inside the door body. Referring to FIG. 28, the upper end of the guide device 200 extends to the same height as the image acquisition module 100. In this case, the door wire W2 may not cross diagonally between the guide device 200 and the image acquisition module 100, but runs along a short path from the image acquisition module 100 to the guide device 200.

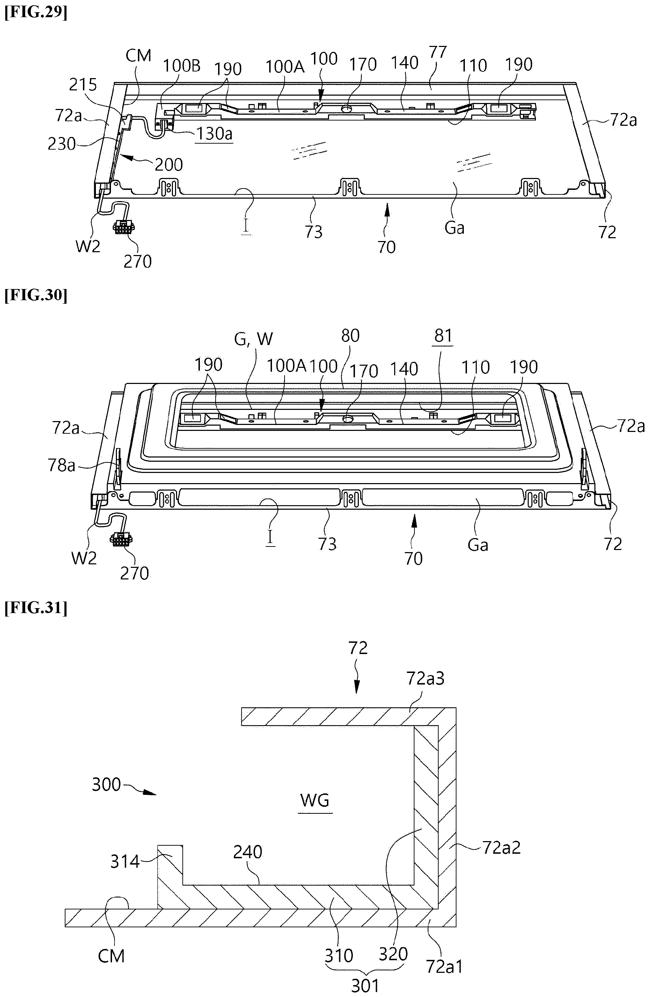

FIG. 29 illustrates a state in which the door connector 270 and the door wire W2 are stored in the guide device 200. The door connector 270 is pulled out through the body opening 73a of the lower frame part 73. In this state, when the rear frame part 80 is assembled to the front frame part 72 as illustrated in FIG. 30, the assembly of the door body may be completed.

Finally, the mating connector 290 may be assembled to the door connector 270 pulled out of the door body. The assembled connector assembly C may be stored in the guide device 200 again.

FIG. 31 is a cross-sectional view illustrating a third embodiment of a guide device 300 according to the present disclosure. As shown, the guide mounting part CM may be provided between the first plate 72a1, the second plate 72a2, and the third plate 72a3 constituting the front side body 72a. The guide device 300 may be arranged on the guide mounting part CM.

The guide device 300 may include a base body 310 stacked on the first plate 72a1. A side body 320 in close contact with the second plate 72a2 may be connected to the base body 310. In this embodiment, a cover body stacked on the third plate 72a3 is omitted. The guide device 300 may be in close contact with two surfaces of the door body. Reference numeral 314 denotes a wire holder for preventing the door wire W2 stored in the guide path GH from deviating.

The guide device 300 may define the guide path GH together with the front side body 72a. The guide path GH may be provided in a central portion of the guide device 300 surrounded by the base body 310, the side body 320, and the third plate 72a3. In addition, one side opened in the guide path GH may be a wire entrance through which the door wire W2 is inserted or pulled out.

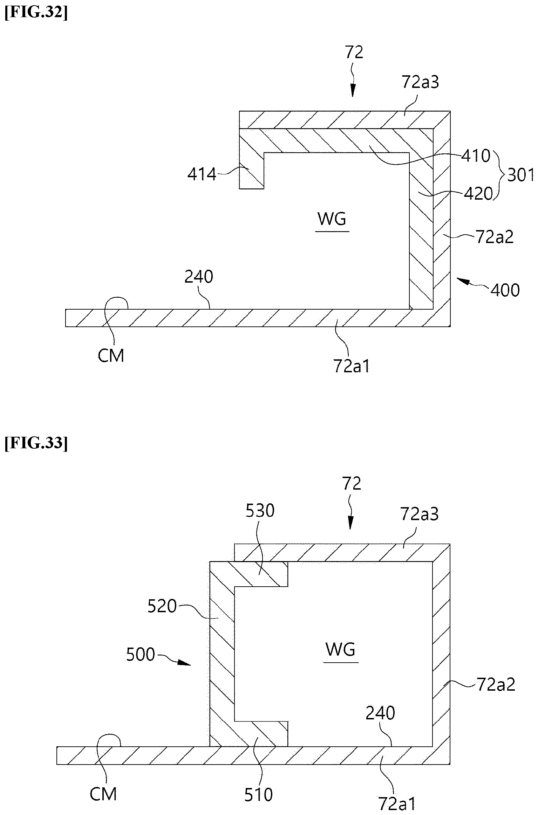

FIG. 32 is a cross-sectional view illustrating a fourth embodiment of a guide device 400 according to the present disclosure. As shown, the guide mounting part CM may be provided between the first plate 72a1, the second plate 72a2, and the third plate 72a3 constituting the front side body 72a. The guide device 400 may be disposed on the guide mounting part CM.

The guide device 400 may include a cover body 410 stacked on the third plate 72a3. A side body 420 that is in close contact with the second plate 72a2 may be connected to the cover body 410. In this embodiment, the base body stacked on the first plate 72a1 is omitted. The guide device 400 may be in close contact with two surfaces of the door body. Reference numeral 414 denotes a wire holder for preventing the door wire W2 stored in the guide path GH from deviating.

The guide device 400 may define the guide path GH together with the front side body 72a. The guide path GH may be provided in a central portion of the guide device 200 surrounded by the cover body 410, the side body 420, and the first plate 72a1. In addition, one side opened in the guide path GH may be a wire entrance through which the door wire W2 is inserted or pulled out.

FIG. 33 is a cross-sectional view illustrating a fifth embodiment of a guide device 500 according to the present disclosure. As shown, the guide mounting part CM may be provided between the first plate 72a1, the second plate 72a2, and the third plate 72a3 constituting the front side body 72a. The guide device 500 may be disposed on the guide mounting part CM.

In this embodiment, the guide device 500 may block the entrance of the guide mounting part CM. In this way, based on the cross section, the guide path GH may be an inner space which is blocked in all directions. More precisely, the guide device 500 may include a base body 510 stacked on the first plate 72a1. A side body 520 facing the second plate 72a2 may be connected to the base body 510. The side body 520 may include a cover body 530 stacked on the third plate 72a3. The guide device 500 may be in close contact with three surfaces of the door body.

The guide device 500 may define the guide path GH together with the front side body 72a. The guide path GH may be provided in a central portion of the guide device 500 surrounded by the side body 520, the first plate 72a1, the second plate 72a2, and the third plate 72a3.

In another embodiment, although not shown, the guide device 200 may include a base body and a cover body connected to the base body and having a curved surface. Accordingly, the guide path GH may have a semicircular cross-sectional shape. As another example, the guide path GH may have a circular or oval cross-sectional shape.

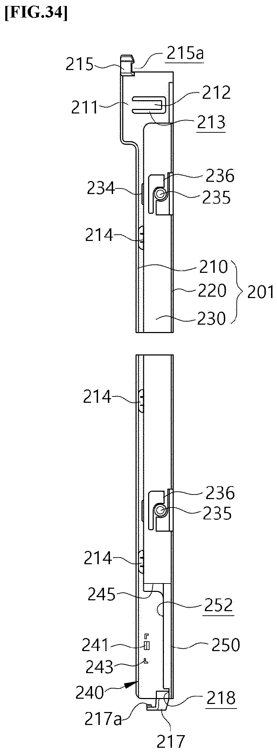

Referring to FIG. 34, a sixth embodiment of the guide device 200 constituting the door 70 for a home appliance according to the present disclosure is illustrated. As shown, the guide device 200 may include a wire unit 201 guiding the door wire W2 and a connector unit 240 fixing the door connector 270. The connector unit 240 may be separated from the wire unit 201 and spaced apart from each other. That is, the guide device 200 may include two components. When the length of the door wire W2 is long, the entire length of the guide device 200 may be reduced by separating the connector unit 240 from the wire unit 201.

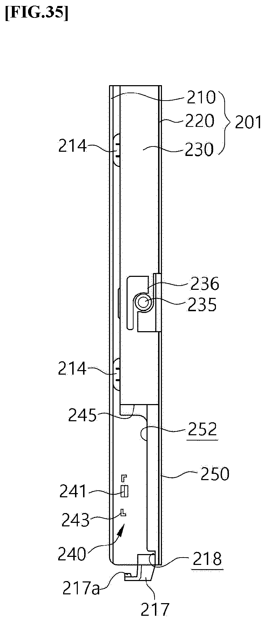

Referring to FIG. 35, a seventh embodiment of the guide device 200 constituting the door 70 for a home appliance according to the present disclosure is illustrated. As shown, the switching holder may be omitted from the guide device 200. Only one elastic support protrusion 235 may be provided in the guide device 200. The guide leg 212 may be omitted from the guide device 200.

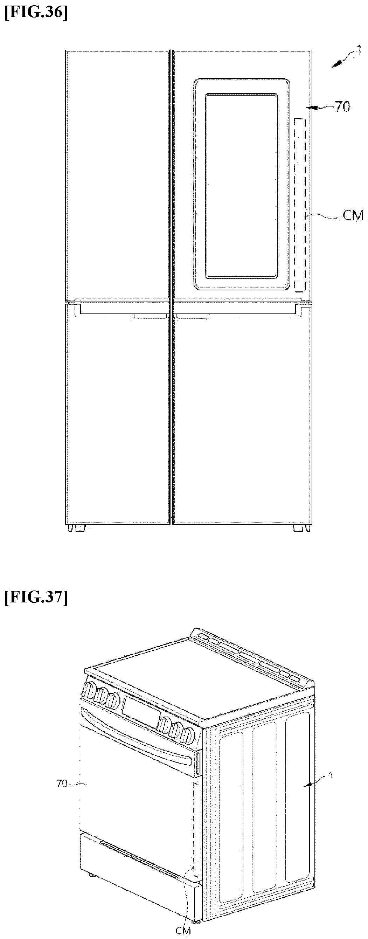

Referring to FIG. 36, a refrigerator to which the door 70 for a home appliance according to the present disclo sure is applied is illustrated. As shown, the door 70 of the present disclosure may be applied to the refrigerator. In this case, the guide device 200 may be disposed along one side of the door 70. The mating wire W1 pulled out of the guide device 200 may extend into a main body of the refrigerator. The electronic components may be a lighting device 180 for lighting the inside of the door 70 of the refrigerator, a touch display for manipulation, or the like.

Referring to FIG. 37, an oven to which the door 70 for a home appliance according to the present disclosure is applied is illustrated. As shown, the door 70 of the present disclosure may be applied to a general oven instead of a built-in method. In this case, the guide device 200 may be disposed along one side of the door 70. The mating wire W1 pulled out of the guide device 200 may extend to a lower portion of the oven body and into the oven body.

The above description is merely an exemplary description of the technical idea of the present disclosure, and various modifications and modifications may be made without departing from the essential characteristics of the present disclosure. The scope of protection of the present disclosure should be interpreted by the following claims.

### Reference Numerals

10: Main body
70: Door
72: Front frame part
72a: Front side body
72a1: first plate
72a2: second Plate
72a3: third Plate
72a3': Protrusion fastening hole
72b: Front lower plate
72c: Front opening
77: Upper frame part
77a: Frame outlet
77b: Upper fastening part
80: Rear frame part
81: Rear penetration tube
82: Rear side plate
90: Inner frame part
91: Inner penetration tube
92: Inner side plate
100: Image acquisition module
170: Image sensing device
180: Lighting device
200: Guide device
201: Guide housing
210: Base body
211: Extension board
211a: Wire seating surface
212: Guide leg
214: Wire holder
215: Switching holder
217: Hanging Hook
218: Guide opening
220: Side Body
230: Cover body
234: Wire catching protrusion
235: Elastic support protrusion
240: Connector holder
241,243: Connector fixing arm
250: Connector coupling part
252: Connector exposure part
280: Guide Cover
281: Cover plate
285: Cover holder
287: Hook assembly piece
288: Cover opening
289: Connector holder
C: Connector assembly
CH: Guide exposure part
CM: Guide Mounting part
W1: Mating Wire
W2: Door wire
WE: Wire entrance
WH: Guide path

## Claims

1. A door for a home appliance comprising:
a door body coupled to a home appliance and having electronic components disposed therein; and
a guide device (200, 300,400, 500) disposed on the door body and storing a door wire (W2) connected to the electronic components,
wherein the guide device (200) is configured to move in a first direction to be disposed on the door body, and
wherein the guide device (200) is supported by the door body in a second direction different from the first direction.

2. The door of claim 1, wherein the guide device (200) is configured to slide in the first direction along the surface of the door body.

3. The door of claim 1 or 2, wherein the guide device (200) is configured to be supported by the door body in the second direction at a plurality of points.

4. The door according to any one of claims 1 to 3, wherein the guide device (200) includes an elastic support part configured to be elastically deformed in the second direction, and the elastic support part is elastically supported by being pressed against a surface of the door body.

5. The door of claim 4, wherein the guide device (200) includes a plurality of elastic support parts, and the plurality of elastic support parts are elastically supported on different surfaces of the door body, respectively, and/or
wherein the elastic support part includes:
a guide leg (212) configured to be elastically deformed in a central direction of a guide path (GH) from a first surface of the guide device (200); and
an elastic support protrusion (235) configured to be elastically deformed in a central direction of the guide path (GH) from a second surface opposite to the first surface.

6. The door according to any one of claims 1 to 3, wherein the guide device (200) includes an elastic support protrusion (235) configured to be elastically deformed in the second direction,
wherein, when the elastic support protrusion (235) is inserted into a protrusion fastening hole (72a3') provided in the door body, the elastic support protrusion (235) is restored its original shape to be caught in the protrusion fastening hole (72a3').

7. The door according to any one of claims 1 to 6, wherein the guide device (200) includes a base body (210) seated on a surface of the door body,
wherein the base body (210) includes a guide leg (212) that is configured to be elastically deformed in the second direction by being pressed against a surface of the door body.

8. The door of claim 1, wherein the door body includes an edge part (72a) forming an edge of the door body,
wherein the edge part (72a) includes:
a first plate (72a1) constituting a first surface;
a second plate (72a2) constituting a second surface bent from the first surface (72a1); and
a third plate (72a3) constituting a third surface bent from the second surface (72a2) and facing the first surface (72a1),
wherein a mounting inlet is opened between the first plate (72a1) and the third plate (72a3) in a direction facing the second plate (72a2),
wherein the guide device (200) is configured to be moved in the first direction and disposed between the first plate (72a1) and the third plate (72a3) through the mounting inlet.

9. The door of claim 8, wherein the guide device (200) includes an elastic support part that configured to be elastically deformed by being pressed against the first plate (72a1) or the third plate (72a3), and/or
wherein the guide device (200) includes:
a base body (210) that is seated on the door body and facing the first plate (72a1) of the door body;
a side body (220) that is erected at one end of the base body (210) and faces the second plate (72a2) of the door body; and
a cover body (230) that is extending from the side body (220) to face the base body (210) and facing the third plate (72a3) of the door body,
wherein a guide path (GH) is provided between the base body (210), the side body (220) and the cover body (230),
wherein the base body (210) or the cover body (230) is supported by the door body in the second direction.

10. The door of claim 1, wherein the guide device (200) includes a guide leg (212) and an elastic support protrusion (235) that are configured to be elastically deformed in opposite directions and elastically supported in the second direction by the door body, respectively, and
wherein a height between one end of the guide leg (212) and one end of the elastic support protrusion (235) is higher than a height of a guide mounting part (CM) provided in the door body.

11. The door of claim 1, wherein a door panel (G) is arranged at the center of the door body, the door panel (G) is provided with a viewing part (V) that allows a storage space provided inside the home appliance to be seen through, and an installation area (T1-T4) is provided around the outside of the viewing part (V).

12. The door of claim 1 or 11, wherein the guide device (200) includes:
a fixing end provided at one end portion of the guide device (200) and supported at a first point of the door body; and
a rotating end provided at the other end portion of the guide device (200) configured to be rotated around the fixing end and supported at a second point of the door body.

13. The door of claim 12, wherein the rotating end is provided with a guide leg (212) that is configured to be elastically deformed in the second direction by the door body at the second point of the door body, and/or
wherein an elastic support protrusion (235) elastically deformed in the second direction by the door body is provided between the fixing end and the rotating end, and wherein the elastic support protrusion (235) is pressed against a surface of the door body or inserted into a protrusion fastening hole (72a3') formed in the door body.

14. The door of claim 1, wherein a wire entrance (WE) into which a door wire (W2) is inserted is opened at one side of a guide path (GH), and
wherein the guide device (200) includes a wire holder (214) protruding from the guide path (GH) in a direction of narrowing the wire entrance (WE).

15. The door of claim 14, wherein the wire holder (214) is configured to be elastically deformed in the second direction to widen the wire entrance (WE), and/or
wherein the wire holder (214) includes:
a guide surface (214b) provided in a direction inclined upward toward the inside of the guide path (GH); and
a support surface (214c) connected to the guide surface (214b) and erected in the direction of blocking one end of the guide path (GH),
wherein the door wire (W2) is disposed between the support surface (214c) and a surface of the guide path (GH), and/or
wherein the wire entrance (WE) includes a wire catching protrusion (234) protruding in a direction of narrowing the wire entrance (WE), and the wire catching protrusion (234) is disposed closer to the wire entrance (WE) than the wire holder (214).
